# EUROPEAN PATENT SPECIFICATION

(11) **EP 3 420 786 B1**
(45) Date of publication and mention of the grant of the patent: **23.12.2020**
(21) Application number: 17789800.4
(22) Date of filing: 03.04.2017
(51) Int. Cl.: H05K 9/00, C09J 11/04, C09J 9/02, C09J 163/00, C09J 167/00

(54) **SHIELDING MEMBER AND ELECTRONIC DEVICE INCLUDING THE SAME**
ABSCHIRMUNGSELEMENT UND ELEKTRONISCHE VORRICHTUNG DAMIT
ÉLÉMENT DE BLINDAGE ET DISPOSITIF ÉLECTRONIQUE COMPRENANT LEDIT ÉLÉMENT

(30) Priority: 29.04.2016 KR 20160052622
(43) Date of publication of application: 02.01.2019
(73) Proprietor: Samsung Electronics Co., Ltd., Suwon-si, Gyeonggi-do 16677 (KR)
(72) Inventor: BANG, Jung-Je, Suwon-si Gyeonggi-do 16561 (KR); PARK, Min, Suwon-si Gyeonggi-do 16602 (KR); YE, Jae-Heung, Suwon-si Gyeonggi-do 16676 (KR); LEE, Yong-Won, Seongnam-si Gyeonggi-do 13597 (KR); KIM, Sang-Seob, Suwon-si Gyeonggi-do 16505 (KR); KIM, Jun-Yeong, Suwon-si Gyeonggi-do 16505 (KR)
(74) Representative: HGF
(86) International application number: PCT/KR2017/003638
(87) International publication number: WO 2017/188615

(56) References cited:
- WO-A1-2004/075616
- WO-A1-2012/105394
- KR-A- 20150 083 018
- KR-B1- 101 272 397
- KR-B1- 101 424 723
- KR-B1- 101 552 976
- US-A1- 2010 294 559
- US-A1- 2012 127 578
- US-A1- 2014 326 484
- US-A1- 2015 305 144

## Description

### Technical Field

Various embodiments of the present disclosure relate to an electronic device, for example, a shielding member for preventing electromagnetic wave interference and/or an electronic device including the same.

### Background Art

Generally, electronic devices refer to devices that perform particular functions based on embedded programs, such as home appliances, electronic notes, portable multimedia players (PMPs), and mobile communication terminals, tablet personal computers (PCs), video/audio devices, desktop/laptop computers, vehicle navigation systems, and so forth. For example, these electronic devices may output stored information in the form of sound, images, and so forth. With the increasing integration of electronic devices and the common use of ultra-high-speed and large-volume wireless communication, various functions have been recently provided through a single mobile communication terminal. For example, an entertainment function such as games, a multimedia function such as music/video playback, a communication and security function for mobile banking, and a function such as schedule management, electronic wallets, or the like, as well as a communication function have been integrated into a single electronic device.

The high integration of an electronic device may mean miniaturization of electronic parts mounted on a circuit board and thus improvement in the performance of the electronic device. The electronic part may be manufactured in the form of an integrated circuit (IC) chip on which one circuit device (e.g., a processor, an audio module, a power management module, a wireless frequency module, etc.) is mounted, or in the form of one integrated circuit chip on which a plurality of circuit devices are integrated.

A portable electronic device such as a mobile communication terminal may have mounted thereon various forms of antenna devices to secure convenience of access to a wireless network. For example, a portable electronic device may include antenna devices for accessing wireless networks having different operating frequency bands, such as near field communication (NFC), Bluetooth, a wireless local area network (LAN), a commercial wireless network (e.g., a 3^{rd}-Generation (3G) mobile communication network, a 4^{th}-Generation (4G) mobile communication network, etc.), and so forth.

Highly-integrated integrated circuit chip(s) may cause more electromagnetic waves, and the overall operating performance of integrated circuit chip(s) and/or the electronic device may degrade due to interference of the electromagnetic waves. In a miniaturized electronic device, e.g., a mobile communication terminal used usually while being carried with a user, integrated circuit chips may be disposed densely and in adjacent to an antenna device (e.g., a radiating conductor). Such arrangement of integrated circuit chips and/or antenna devices may deteriorate the operating performance of the integrated circuit chips or the operating environment of the antenna devices.

US 2015/305144 A1 discloses a shield film for a portable device. US 2014/326484 A1 discloses a similar shield film. US 2010/294559 A1 discloses a shielding film for an electronic device. Further arrangements are disclosed in WO 2012/105394 A1 and WO 2004/075616 A1.

The above information is presented as background information only to assist with an understanding of the present disclosure. No determination has been made, and no assertion is made, as to whether any of the above might be applicable as prior art with regard to the present disclosure.

### Disclosure of Invention

### Technical Problem

To address the above-discussed deficiencies, it is an object to provide a shielding member capable of alleviating or preventing electromagnetic wave interference between integrated circuit (IC) chips and/or between IC chip(s) and an antenna device, and an electronic device including the shielding member.

Various embodiments of the present disclosure also provide a shielding member stably maintaining a state of a circuit board being connected to a ground and an electronic device including the shielding member.

Various embodiments of the present disclosure provide a shielding member which is stacked with an electronic part such as an IC chip, etc., and contributes to miniaturization of an electronic device, and the electronic device including the shielding member.

### Solution to Problem

According to various embodiments of the present disclosure, there is provided an electronic device comprising: a circuit board comprising at least one ground pad; and a shielding member attached to the circuit board and electrically connected to the ground pad, wherein the shielding member comprises: an insulating layer; a shielding layer formed on a surface of the insulating layer; and a resin adhesive layer formed on a surface of the shielding layer, wherein the resin adhesive layer comprises a thermoplastic resin adhesive comprising electrically conductive powder, and wherein the shielding layer and the resin adhesive layer have smaller areas than that of the insulating layer.

Other aspects, advantages, and salient features of the disclosure will become apparent to those skilled in the art from the following detailed description, which, taken in conjunction with the annexed drawings, discloses exemplary embodiments of the disclosure.

Before undertaking the DETAILED DESCRIPTION below, it may be advantageous to set forth definitions of certain words and phrases used throughout this patent document: the terms "include" and "comprise," as well as derivatives thereof, mean inclusion without limitation; the term "or," is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, such a device may be implemented in hardware, firmware or software, or some combination of at least two of the same. It should be noted that the functionality associated with any particular controller may be centralized or distributed, whether locally or remotely. Definitions for certain words and phrases are provided throughout this patent document, those of ordinary skill in the art should understand that in many, if not most instances, such definitions apply to prior, as well as future uses of such defined words and phrases.

### Advantageous Effects of Invention

The shielding member according to various embodiments of the present disclosure includes the thermoplastic resin adhesive to which the conductive powder is added, thereby maintaining stable connection with the ground of the circuit board after the adhesive (and/or the adhesive layer) is hardened. For example, the shielding member according to various embodiments of the present disclosure, when mounted on or adhered to the circuit board with the IC chip therebetween, is connected to the ground, thereby blocking leakage of electromagnetic waves generated from the IC chip and preventing external electromagnetic waves from reaching the IC chip. According to various embodiments, the resin adhesive layer includes the thermoplastic resin adhesive, thus being easily separated from the circuit board by being heated for repair/maintenance, while stably maintaining the hardened state. In an embodiment, the shielding member is a shielding member of a film type including the insulating layer, the shielding layer, the resin adhesive layer, and so forth, and may provide a stable electromagnetic wave shielding function while having a small influence of the shielding member upon the thickness of the electronic device.

### Brief Description of Drawings

For a more complete understanding of the present disclosure and its advantages, reference is now made to the following description taken in conjunction with the accompanying drawings, in which like reference numerals represent like parts:
FIG. 1 is an exploded perspective view of an electronic device according to various embodiments of the present disclosure;
FIG. 2 is a block diagram of an electronic device according to various embodiments of the present disclosure;
FIG. 3 is an exploded perspective view of a shielding member of an electronic device according to one of various embodiments of the present disclosure;
FIG. 4 is a cross-sectional view of a shielding member of an electronic device according to another one of various embodiments of the present disclosure;
FIG. 5 is an exploded perspective view of a shielding member of an electronic device according to another one of various embodiments of the present disclosure;
FIG. 6 is an exploded perspective view of a shielding member of an electronic device according to another one of various embodiments of the present disclosure;
FIG. 7 is a cross-sectional view of a shielding member of an electronic device according to another one of various embodiments of the present disclosure; and
FIGS. 8 through 10 are cross-sectional views of various structures of a shielding member of an electronic device according to other embodiments of the present disclosure.

Throughout the drawings, like reference numerals will be understood to refer to like parts, components, and structures.

### Mode for Invention

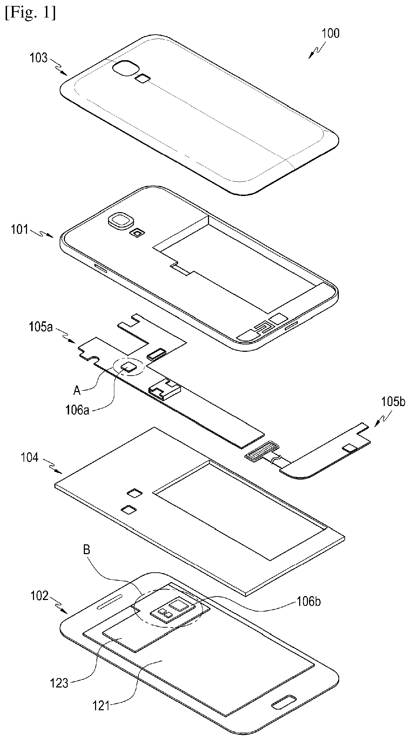

FIGURES 1 through 10, discussed below discuss embodiments and features as defined by the appended claims.

Various changes may be made to the present which fall within the protection as defined in the appended claims.

Although ordinal numbers such as "first", "second", and so forth will be used to describe various components of the present disclosure, those components are not limited by the terms. These terms may be used for the purpose of distinguishing one element from another element. The term "and/or" includes a combination of a plurality of related provided items or any one of the plurality of related provided items. The term "or" includes any one of the elements listed or, in the alternative, at least one or more of the elements listed.

Relative terms used based on illustration in the drawings, such as a "front side", a "rear side", a "top surface", a "bottom surface", and the like, may be replaced with ordinal numbers such as "first", "second", and the like. The order of the ordinal numbers such as "first", "second", and the like is a mentioned order or an arbitrarily set order, and may be changed as needed.

The terms used in the present disclosure are for the purpose of describing particular exemplary embodiments only and are not intended to be limiting. The singular forms are intended to include the plural forms as well, unless the context clearly indicates otherwise. The term "include" or "has" used in the present disclosure is to indicate the presence of features, numbers, steps, operations, elements, parts, or a combination thereof described in the specifications, and does not preclude the presence or addition of one or more other features, numbers, steps, operations, elements, parts, or a combination thereof.

All of the terms used herein including technical or scientific terms have the same meanings as those generally understood by an ordinary skilled person in the related art unless they are defined other. The terms defined in a generally used dictionary should be interpreted as having meanings that are the same as or similar with the contextual meanings of the relevant technology and should not be interpreted as having ideal or exaggerated meanings unless they are clearly defined in the present disclosure.

In various embodiments of the present disclosure, an electronic device may be an arbitrary device having a touch panel and may be referred to as a terminal, a portable terminal, a mobile terminal, a communication terminal, a portable communication terminal, a portable mobile terminal, a display, or the like.

For example, the electronic device may be a smart phone, a cellular phone, a navigation device, a game console, a television (TV), a vehicle head unit, a laptop computer, a tablet computer, a personal media player (PMP), a personal digital assistant (PDA), or the like. The electronic device may be implemented with a pocket-size portable communication terminal having a wireless communication function. The electronic device may be a flexible device or a flexible display.

The electronic device may communicate with an external electronic device such as a server or may work by cooperating with the external electronic device. For example, the electronic device may transmit an image captured by a camera and/or position information detected by a sensor unit to the server over a network. A network may be, but not limited to, a mobile or cellular communication network, a local area network (LAN), a wireless local area network (WLAN), a wide area network (WAN), Internet, a small area network (SAN), or the like.

FIG. 1 is an exploded perspective view of an electronic device 100 according to various embodiments of the present disclosure.

Referring to FIG. 1, the electronic device 100 according to various embodiments of the present disclosure may include at least one shielding member 106a or 106b mounted on a circuit board 105a or 105b or 123. The electronic device 100, for example, a mobile communication terminal, may include a housing 101, a front cover 102, and a rear cover 103, and may receive the at least one circuit board 105a or 105b or 123 and a support member 104 in the housing 101. Hereinbelow, in a detailed description, a 'circuit board', and a 'flexible printed circuit board' may be separately described when necessary. However, the present disclosure is not limited to a detailed embodiment, and the 'circuit board' mentioned in the following detailed description may be used as a meaning including the 'flexible printed circuit board'.

According to various embodiments, the housing 101 forms a body of the electronic device 100, and may receive various electronic parts, e.g., the at least one circuit board 105a or 105b or 123. The support member 104 is received in the housing 101 to supplement and improve the rigidity of the electronic device 100, and separates installation spaces of some electronic parts from each other. For example, if the electronic device 100 includes a display (e.g., a display 121), the support member 104 may separate an installation space of the display 121 from an installation space of an integrated circuit (IC) chip such as a processor, etc., to prevent other electronic parts from interfering with the display 121.

According to various embodiments, the front cover 102 is mounted on a front surface of the housing 101 to form an exterior of the electronic device 100 together with at least a portion of the housing 101, and may include, for example, a window member in which the display 121 is integrated. In an embodiment, the front cover 102 may include a touch panel integrated in the display 121 or the window member. For example, the front cover 102 may be used as an input device for obtaining a user's touch input as well as an output device for outputting a screen in the electronic device 100.

According to various embodiments, the front cover 102 may include a circuit board (e.g., a flexible printed circuit board 123) connected to the display 121 and/or the touch panel. On the flexible printed circuit board 123 may be mounted electronic parts such as a driving IC chip for driving the display 121 and/or the touch panel and so forth, and one (e.g., a shielding member indicated by 106b) of shielding members of the electronic device 100 may be mounted between the electronic parts on the flexible printed circuit board 123.

According to various embodiments, the front cover 103 is mounted on a rear surface of the housing 101 to form the exterior of the electronic device 100 together with at least a portion of the housing 101 and/or at least a portion of the front cover 102. In an embodiment, the rear cover 103 may be mounted removably from the housing 101, and the user may attach or detach various storage medium (e.g., a subscriber identification module (SIM) card, a memory card, etc.) or replace a battery after removing the rear cover 103. In another embodiment, the rear cover 103 forms a uni-body with the housing 101, such that the user may not be able to replace a battery arbitrarily.

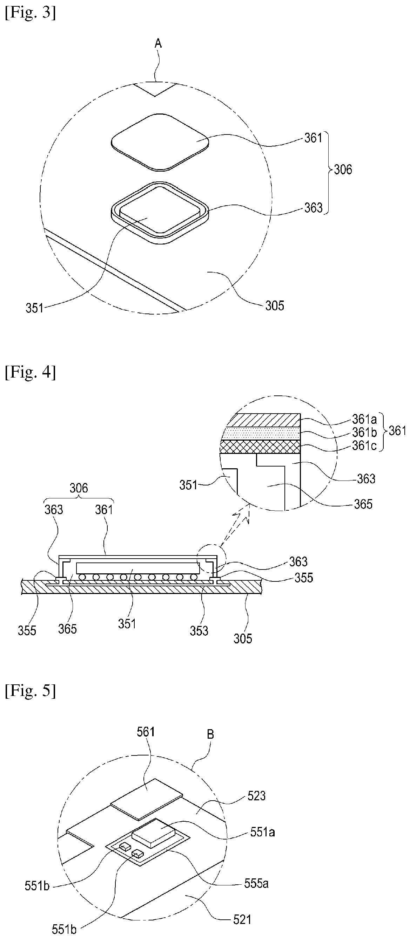

According to various embodiments, one circuit board or plural circuit boards (e.g., a circuit board 105a or 105b) may be provided in the housing 101 based on designing of an internal space of the electronic device 100. In an embodiment, various IC chips such as a processor, an audio module, a communication module, etc., may be disposed on the circuit board 105a or 105b, and another shielding member (e.g., a shielding member 106a) is attached to the circuit board 105a or 105b between IC chips. The mounting structures of the shielding member(s) 106a and 106b will be described in more detail with reference to FIGS. 3 through 10.

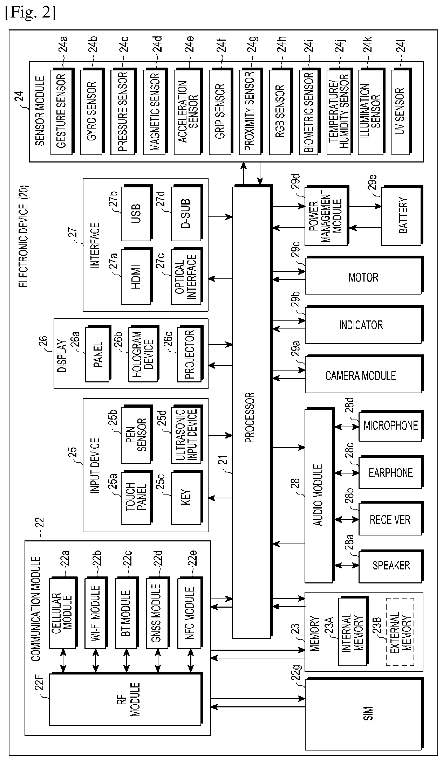

FIG. 2 is a block diagram of an electronic device 20 according to various embodiments of the present disclosure. The electronic device 20 may form the entire electronic device 100 illustrated in FIG. 1 or a part of the electronic device 101 illustrated in FIG. 1. The electronic device 20 may include one or more processors (e.g., application processors (APs)) 21, a communication module 22, a subscriber identification module (SIM) 22g, a memory 23, a sensor module 24, an input module 25, a display 26, an interface 27, an audio module 28, a camera module 29a, a power management module 29d, a battery 29e, an indicator 29b, and a motor 29c. The processor 21 controls multiple hardware or software components connected to the processor 21 by driving an Operating System (OS) or an application program, and performs processing and operations with respect to various data. The processor 21 may be implemented with, for example, a system on chip (SoC). According to an embodiment of the present disclosure, the server 21 may include a GPU and/or an image signal processor. The processor 21 may include at least some of the elements illustrated in FIG. 2 (e.g., the cellular module 22a). The processor 21 loads a command or data received from at least one of other elements (e.g., a non-volatile memory) into a volatile memory to process the command or data, and stores result data in the non-volatile memory.

The communication module 22 may include, for example, at least one of the cellular module 22a, a WiFi module 22b, a Bluetooth (BT) module 22c, a GNSS module 22d, a near field communication (NFC) module 22e, and a radio frequency (RF) module 22f. The cellular module 22a may provide, for example, a voice call, a video call, a text service, or an Internet service over a communication network. According to an embodiment, the cellular module 22a identifies and authenticates the electronic device 20 in a communication network by using the SIM 22g (e.g., a SIM card). According to an embodiment, the cellular module 22a performs at least one of functions that may be provided by the processor 21. According to an embodiment, the cellular module 22a may include a communication processor (CP). According to some embodiment, at least some (e.g., two or more) of the cellular module 22a, the WiFi module 22b, the BT module 22c, the GNSS module 22d, and the NFC module 22e may be included in one integrated chip (IC) or IC package. The RF module 22f may, for example, transmit and receive a communication signal (e.g., an RF signal). The RF module 22f may include a transceiver, a power amp module (PAM), a frequency filter, a low noise amplifier (LNA), or an antenna. According to another embodiment, at least one of the cellular module 22a, the WiFi module 22b, the BT module 22c, the GNSS module 22d, and the NFC module 22e may transmit and receive an RF signal through the separate RF module. The SIM 22g may, for example, include a card including an SIM or an embedded SIM, and may include unique identification information (e.g., an integrated circuit card identifier (ICCID) or subscriber information (e.g., an international mobile subscriber identity (IMSI)).

The memory 23 may include an internal memory 23a or an external memory 23b. The internal memory 23a may, for example, include at least one of a volatile memory (e.g., dynamic random access memory (DRAM), static RAM (SRAM), synchronous dynamic RAM (SDRAM), etc.), and a non-volatile memory (e.g., one time programmable read only memory (OTPROM), programmable ROM (PROM), erasable and programmable ROM (EPROM), electrically erasable and programmable ROM (EEPROM), etc.), mask ROM, flash ROM, a flash memory, and a solid state drive (SSD). The external memory 23b may further include flash drive, for example, compact flash (CF), secure digital (SD), micro-SD, mini-SD, extreme Digital (xD), a multi-media card (MMC), or a memory stick. The external memory 23b may be functionally or physically connected with the electronic device 20 through various interfaces.

The sensor module 24 measures physical quantity or senses an operation state of the electronic device 20 to convert the measured or sensed information into an electric signal. The sensor module 24 may, for example, include at least one of a gesture sensor 24a, a gyro sensor 24b, a pressure sensor 24c, a magnetic sensor 24d, an acceleration sensor 24e, a grip sensor 24f, a proximity sensor 24g, a color sensor 24h (e.g., RGB sensor), a biometric sensor 24i, a temperature/humidity sensor 24j, an illumination sensor 24k, and a ultraviolet (UV) sensor 241. Additionally or alternatively, the sensor module 24 may include an E-nose sensor (not shown), an electromyography (EMG) sensor (not shown), an electroencephalogram (EEG) sensor (not shown), an electrocardiogram (ECG) sensor (not shown), an infrared (IR) sensor, an iris sensor, and/or a fingerprint sensor. The sensor module 24 may further include a control circuit for controlling at least one sensor included therein. In some embodiment, the electronic device 20 may further include a processor configured to control the sensor module 24 as part of or separately from the processor 21, to control the sensor module 24 during a sleep state of the processor 21.

The input module 25 may include, for example, a touch panel 25a, a (digital) pen sensor 25b, a key 25c, or an ultrasonic input device 25d. The touch panel 25a may use at least one of a capacitive type, a resistive type, an IR type, or an ultrasonic type. The touch panel 25a may further include a control circuit. The touch panel 25a may further include a tactile layer to provide tactile reaction to the user. The (digital) pen sensor 25b may include a recognition sheet which is a part of the touch panel 25a or a separate recognition sheet. The key 25c may also include, for example, a physical button, an optical key, or a keypad. The ultrasonic input device 25d senses ultrasonic waves generated by an input means through a microphone (e.g., the microphone 28d) and checks data corresponding to the sensed ultrasonic waves.

The display 26 may include a panel 26a, a hologram device 26b, a projector 26c, and/or a control circuit for controlling them. The panel 26a may be implemented to be flexible, transparent, or wearable. The panel 26a may be configured with the touch panel 25a in one module. According to an embodiment, the panel 26a may include a pressure sensor (or a "force sensor", interchangeably used hereinafter) capable of measuring a strength of a pressure by a user's touch. The pressure sensor may be implemented integrally with the touch panel 25a or may be implemented as one or more sensors separate from the touch panel 25a. The hologram device 26b shows a stereoscopic image in the air by using interference of light. The projector 26c displays an image onto an external screen through projection of light. The screen may be positioned inside or outside the electronic device 20. According to an embodiment, the interface 27 may include a high-definition multimedia interface (HDMI) 27a, a universal serial bus (USB) 27b, an optical communication 27c, or a D-subminiature 27d. Additionally or alternatively, the interface 27 may include, for example, an MHL interface, an SD card/MMC interface, or an IrDA standard interface.

The audio module 28 bi-directionally converts sound and an electric signal. The audio module 28 processes sound information input or output through the speaker 28a, the receiver 28b, the earphone 28c, or the microphone 28d. The camera module 29a is, for example, a device capable of capturing a still image or a moving image, and according to an embodiment, may include one or more image sensors (e.g., a front sensor or a rear sensor), a lens, an image signal processor (ISP), or a flash (e.g., an LED, a xenon lamp, etc.). The power management module 29d manages power of the electronic device 20. According to an embodiment, the power management module 29d may include a power management integrated circuit (PMIC), a charger IC, or a battery fuel gauge. The PMIC may have a wired and/or wireless charging scheme. The wireless charging scheme includes a magnetic-resonance type, a magnetic induction type, and an electromagnetic type, and for wireless charging, an additional circuit, for example, a coil loop, a resonance circuit, or a rectifier may be further included. The battery gauge measures the remaining capacity of the battery 29e or the voltage, current, or temperature of the battery 29e during charging. The battery 29e may include a rechargeable battery and/or a solar battery.

The indicator 29b displays a particular state, for example, a booting state, a message state, or a charging state, of the electronic device 20 or a part thereof (e.g., the processor 21). The motor 29c converts an electric signal into mechanical vibration or generates vibration or a haptic effect. The electronic device 20 may include a device for supporting the mobile TV (e.g., a GPU) to process media data according to a standard such as digital multimedia broadcasting (DMB), digital video broadcasting (DVB), or mediaFlo™. Each of the foregoing elements described herein may be configured with one or more components, names of which may vary with a type of the electronic device. In various embodiments, some components of the electronic device (e.g., the electronic device 20) may be omitted or may further include other elements, and some of the components may be coupled to form one entity and identically perform functions of the components before being coupled.

FIG. 3 is a perspective view of a shielding member 306 of an electronic device according to one of various embodiments of the present disclosure. FIG. 4 is a perspective view of the shielding member 306 of an electronic device according to another one of various embodiments of the present disclosure.

Referring to FIGS. 3 and 4, the shielding member 306 is a shielding member (e.g., the shielding member 106a) disposed on, for example, a region A of FIG. 1, and may include a shielding film 361 and a shield frame 363. The shielding member 306 is mounted on a circuit board (e.g., the circuit board 105a of FIG. 1) to isolate a space (e.g., a space 365) on the circuit board 305 from the other space. For example, the shielding member 306 may be disposed to enclose an IC chip 351 mounted on the circuit board 305.

According to an embodiment, the shield frame 363 is obtained by performing sheet-metal processing with respect to a metal thin plate, and when the shield frame 363 is mounted on the circuit board 305, a top surface of the shield frame 363 may be open. The shielding film 361 is attached to the shield frame 363 to close the open top surface of the shield frame 363. A ground layer 353 is provided inside the circuit board 305, and a ground pad 355 disposed on an outer surface of the circuit board 305 is connected to the ground layer 353. The ground layer 353 provides ground to various electronic parts mounted on the circuit board 305, thereby stabilizing an operating environment of the electronic device (e.g., the electronic device 100 of FIG. 1) and/or the IC chip 351. The shield frame 363 has a closed loop and/or closed curve shape that encloses the circumference of the IC hip 351, and is mounted on the circuit board 305 while being electrically connected to the ground pad 355. For example, the shield frame 363 may substantially provide ground to the IC chip 351.

In an embodiment, the shielding film 361 may be attached to the circuit board 305, and the shielding frame 363 may not be disposed. This will be described in more detail with reference to FIG. 5.

According to various embodiments, the shielding film 361 may include an insulating layer 361a, a shielding layer 361b, and a resin adhesive layer 361c. Versions of the insulating layer 361a have a shape of a film having a thickness of about 5 - 8 micrometers (*µ*m). The shielding layer 361b is formed on a surface of the insulating layer 361a and may include an electrically conductive material layer having a thickness of about 2 - 10 *µ*m, in some embodiments. For example, the shielding layer 361b may include a deposition layer where a copper foil or a conductive material such as copper, gold, silver, etc., having a predetermined thickness is deposited. The resin adhesive layer 361c may include a thermoplastic resin adhesive to which electrically conductive powder is added.

According to various embodiments, the resin adhesive layer 361c is denaturalized into an adhesive having an adhesive property if being heated over a predetermined temperature, and is hardened in a predetermined shape to function as an adhesive layer if being cooled again. For example, if the shielding film 361 arranged on a top surface of the shield frame 363 is pressed, heated, and cooled, as the resin adhesive layer 361 is denaturalized and hardened, the shielding film 361 may be attached and fixed to an upper end of the shield frame 363. The shield film 361 may be attached to the upper end of the shield frame 363 as an edge portion of the shielding film 361, e.g., an edge portion of the resin adhesive layer 361c is denaturalized and hardened. The thermoplastic resin adhesive may include epoxy resin or polyester resin.

In an embodiment, the resin adhesive layer 361c contains conductive powder to electrically connect the shielding member 361, e.g., the shielding layer 361b to the ground pad 355 and/or the ground layer 353. The IC chip 351 is located in a space (e.g., a space 365, which will be referred to as an installation space 365) enclosed by the shield frame 363 and the shielding frame 361, so as to be spatially isolated from the other space and to be electrically isolated from the other space by the shield frame 363 and/ or the shielding frame 361.

According to various embodiments, the installation space 365 may be molded with synthetic resin, e.g., an insulating material. For example, the IC hip 351 may be insulated from the shielding film 361 and/or the shielding frame 363. In an embodiment, another insulating layer disposed on a region corresponding to the IC hip 351 is further provided on a surface of the resin adhesive layer 361c. For example, for insulation between the shielding film 361 and the IC hip 351, a second insulating layer may be further provided on the resin adhesive layer 361c. Molding with synthetic resin or providing of the second insulating layer for insulation between the IC chip 351 and the shielding film 361 may be properly selected based on a manufacturing cost, processing, insulating performance, and so forth.

When the shielding frame 363 is manufactured, the shielding member 361 may be manufactured by processing a metal thin plate in a form that is partially open and globally has a closed top surface. However, as in the above-described embodiment, by manufacturing the shield frame 363 to have the closed top surface by using the shielding film 361, the installation height of the shielding member 306 may be lowered in spite of installation of the shielding member 306. For example, the shielding member 306 according to various embodiments of the present disclosure may stabilize the operating environment of an IC chip while reducing the thickness of the electronic device (e.g., the electronic device 100 of FIG. 1).

In an embodiment, the resin adhesive layer 361c of the shielding film 361 includes a thermoplastic resin adhesive to maintain a constant thickness even after being hardened. A general resin adhesive undergoes a change in its thickness over time after adhesion, which causes a change in an electric resistance (an electric resistance of a resin adhesive layer) between a ground pad (and/or a ground layer) and a shielding layer. For example, the resin adhesive layer 361c according to various embodiments of the present disclosure maintains an electric resistance between the ground pad 355 (and/or the ground layer 353) and the shielding layer 361b low by maintaining a constant thickness after being hardened, thereby securing and maintaining stable shielding performance of the shielding member 306.

In a shielding member using a general resin adhesive, there is a limitation in maintaining an electric resistance between a ground pad and a shielding layer low, so that the shielding layer is formed to have a thickness of about 18 *µ*m or more to secure stable shielding performance, in some embodiments. In the shielding member according to various embodiments of the present disclosure, the resin adhesive layer including the thermoplastic resin adhesive is formed, thereby maintaining an electric resistance between the ground pad and the shielding layer low. For example, in the shielding member according to various embodiments of the present disclosure, with a shielding layer having a thickness of about 2 - 10 *µ*m, shielding performance equal to or higher than that of a shielding member using a general resin adhesive layer may be obtained.

Table 1 shows measurement results of a surface resistance of a general shielding member (and/or a shielding film), and Table 2 shows measurement results of a surface resistance of a shielding member (and/or a shielding film) according to various embodiments of the present disclosure, where the shielding members manufactured under identical conditions (e.g., respective layers of the shielding members have the same thicknesses) are attached to a test printed circuit board and the surface resistance is measured after 30 minutes. In a test printed circuit board, a plurality of printed circuit patterns have been connected to a shielding member independently of each other, and a surface resistance between selected two different printed circuit patterns has been measured.

**[Table 1]**

| Unit: ohm (Ω) | Test Sample | A | B | C | D | E |
|---|---|---|---|---|---|---|
| General Shielding Member | 1 | 3.3 | 3 | 3.8 | 3.6 | 4.3 |
| | 2 | 2.6 | 1.8 | 1.6 | 3 | 5 |
| | 3 | 1.8 | 1.2 | 1.7 | 2.8 | 3.3 |
| | 4 | 2.2 | 3.1 | 2 | 2.9 | 3.5 |
| | 5 | 2.1 | 1.4 | 1.8 | 1.6 | 1.6 |
| | 6 | 0.8 | 0.6 | 0.6 | 0.7 | 0.8 |
| | 7 | 0.7 | 0.6 | 0.6 | 0.6 | 0.5 |
| | 8 | 0.8 | 0.6 | 0.6 | 0.6 | 0.6 |
| | 9 | 0.5 | 0.4 | 0.5 | 0.5 | 0.5 |

**[Table 2]**

| Unit: ohm (Ω) | Test Sample | A | B | C | D | E |
|---|---|---|---|---|---|---|
| Shielding Member-according to various embodiments of the presented disclosure | 1 | 0.2 | 0.3 | 0.2 | 0.3 | 0.2 |
| | 2 | 1.1 | 0.3 | 0.3 | 0.2 | 0.1 |
| | 3 | 0.9 | 0.1 | 0.1 | 0.1 | 0.8 |
| | 4 | 0.7 | 0.5 | 0.5 | 0.6 | 0.7 |
| | 5 | 0.9 | 0.9 | 1 | 0.8 | 0.4 |
| | 6 | 0.7 | 0.5 | 0.4 | 0.5 | 0.8 |
| | 7 | 3 | 0.7 | 0.9 | 0.9 | 1.5 |
| | 8 | 1.5 | 1.5 | 1.7 | 0.8 | 0.5 |
| | 9 | 1.4 | 0.9 | 1.5 | 1.4 | 1.2 |

After shielding member(s) used in resistance measurement of Table 1 and Table 2 are left for seven days (about 170 hours), measurement results of the surface resistance are shown in Table 3 and Table 4.

**[Table 3]**

| Unit: ohm (Ω) | Test Sample | A | B | C | D | E |
|---|---|---|---|---|---|---|
| General Shielding Member | 1 | 11.1 | 13.1 | 9.1 | 31.5 | 12.1 |
| | 2 | 1.9 | 4.4 | 2 | 9 | 2.6 |
| | 3 | 1.9 | 4.7 | 9.4 | 6.3 | 2.9 |
| | 4 | 2.6 | 2.4 | 3 | 2.9 | 2.1 |
| | 5 | 4.2 | 4.2 | 2.2 | 2.7 | 2.9 |
| | 6 | 3.7 | 2.7 | 3.7 | 2.8 | 3.1 |
| | 7 | 7.9 | 3.5 | 3 | 9.2 | 7.6 |
| | 8 | 7.3 | 4.2 | 8.3 | 4.5 | 2.9 |
| | 9 | 9 | 3.6 | 5 | 10 | 2.6 |

**[Table 4]**

| Unit: ohm (Ω) | Test Sample | A | B | C | D | E |
|---|---|---|---|---|---|---|
| Shielding Member-according to various embodiments of the presented disclosure | 1 | 0.3 | 0.3 | 0.3 | 0.4 | 0.2 |
| | 2 | 1.1 | 0.4 | 0.3 | 0.4 | 1.1 |
| | 3 | 0.8 | 0.2 | 0.2 | 0.1 | 1 |
| | 4 | 0.5 | 0.6 | 0.6 | 0.4 | 0.6 |
| | 5 | 0.6 | 0.5 | 0.6 | 0.8 | 0.4 |
| | 6 | 0.6 | 0.6 | 0.4 | 0.4 | 0.6 |
| | 7 | 3.8 | 3 | 3.6 | 2 | 1.6 |
| | 8 | 1.4 | 1.9 | 2.1 | 3.5 | 1.1 |
| | 9 | 1.5 | 1.1 | 1.9 | 1.6 | 1.6 |

As can be seen from the surface resistance measurement results of Table 1 through Table 4, since a change in the surface resistance of the shielding member according to various embodiments of the present disclosure is small, stable connection between a ground layer and a shielding member of a circuit board may be maintained in an actual operating environment after the elapse of a significant time from an initial manufacturing stage. The general shielding member shows a shielding performance of 28 dB, whereas the shielding member according to various embodiments of the present disclosure shows a shielding performance of 39 dB, and improvement in the shielding performance may be known from the surface resistance change measurement results.

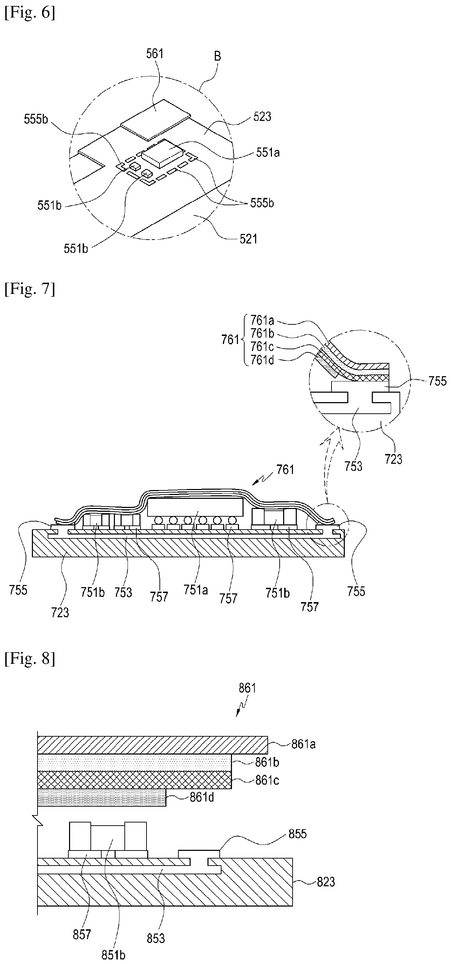

FIG. 5 is an exploded perspective view of a shielding member 561 of an electronic device according to another one of various embodiments of the present disclosure. FIG. 6 is an exploded perspective view of the shielding member 561 of an electronic device according to another one of various embodiments of the present disclosure.

Since the embodiments shown in FIGS. 5 and 6 are different in terms of the structure of the ground pad, identical reference numerals are given and elements will be described separately if needed.

Referring to FIGS. 5 and 6, the shielding member 561 is a shielding member of a film type directly attached to a circuit board 523 that may include at least one IC chip(s) 551a or 551b and ground pad(s) 555a or 555b that is(are) formed on the circumference of the IC chip(s) 551a or 551b on a surface of the circuit board 523. The circuit board 523 may be a flexible printed circuit board (e.g., the flexible printed circuit board 123 of FIG. 1) connected to a display 521 (e.g., the display 121 of FIG. 1) and/or a touch panel.

In an embodiment, the circuit board 521 is a multi-layer circuit board and may include at least one ground layer, and the ground pad(s) 555a or 555b is connected to a ground layer through a via hole, etc. Referring to FIG. 5, the ground pad 555a has a closed curve shape that encloses a region where the IC chip(s) 551a or 551b is arranged. Referring to FIG. 6, a plurality of ground pads 555b are arranged along a closed curve trajectory that encloses the region where the IC chip(s) 551a or 551b is arranged.

For example, in the electronic device according to various embodiments of the present disclosure, when the circuit board is attached to the shielding member, the shielding member is adhered to one ground pad or a plurality of ground pads, such that the shielding member may be electrically connected to the ground layer. The shielding member 561 is used to spatially and/or electrically isolate a space where the IC chip(s) 551a or 551b is arranged, thereby properly selecting the shape of the ground pad 555a or 555b based on the desired shielding performance or the manufacturing cost of the electronic device.

FIG. 7 is a cross-sectional view of a shielding member 761 of an electronic device according to another one of various embodiments of the present disclosure.

Referring to FIG. 7, an electronic device (e.g., the electronic device 100 of FIG. 1) according to various embodiments of the present disclosure may include a circuit board 723 including at least one ground layer 753 and a shielding member 761 attached to a surface of the circuit board 723. Various IC chip(s) 751a or 751b is mounted on the circuit board 723, and the shielding member 761 is attached to the circuit board 723, having at least one of the IC chip(s) 751a or 751b therebetween. The circuit board 723 may include a ground pad 755 connected to the ground layer 753 and/or connection pads 757 for connecting the IC chip(s) 751a or 751b to a printed circuit pattern of the circuit board 723. For example, the IC chip(s) 751a or 751b may be mounted directly on the connection pads 757 through surface mounting or mounted on the circuit board 723 through ball grid array chip bonding.

According to various embodiments, the ground pads 755 are arranged in the shape of a closed curve that encloses the region where the IC chip(s) 751a or 751b is arranged or are arranged along a closed curve trajectory. The ground pads 755 are connected to the ground layer 753 through a via hole, etc., formed on the circuit board 723, and once the shielding member 761 is adhered to the ground pads 755, the ground pads 755 may electrically connect the shielding layer to the ground layer 753.

In an embodiment, the shielding member 761 may be a shielding member of a film type including an insulating layer 761a, a shielding layer 761b, and a resin adhesive layer 761c, and when attached to the circuit board 723, may be denaturalized flexibly to correspond to the height of the IC chip(s) 751a or 751b. The structures of the insulating layer 761a, the shielding layer 761b and/or the adhesive layer 761c may be understood easily from the previous embodiments, and thus will not be described in detail.

In an embodiment, the resin adhesive layer 761c may include a thermoplastic resin adhesive to which conductive powder is added, and may be hardened while being cooled, after be denaturalized by being heated. After being hardened, the resin adhesive layer 761c maintains its thickness constant, such that the shielding member 761 maintains its state of being attached to the circuit board 723. In an embodiment, after being hardened, the resin adhesive layer 761c maintains its constant thickness constant, thereby maintaining electric connection between the shielding layer 761b and the ground layer 753 stable.

According to various embodiments, the shielding member 761 is a shielding member of a film type and is directly attached to the circuit board, such that an inner side of the shielding member 761 may directly contact a top surface of the IC chip(s) 751a or 751b. For example, since the surface of the IC chip(s) 751a or 751b directly contacts the resin adhesive layer 761c (and/or the shielding layer 761b), the shielding member 761 may further include a second insulating layer 761d to prevent the IC chip(s) 751a or 751b and the resin adhesive layer 761c (and/or the shielding layer 761b) from being electrically short-circuited.

According to various embodiments, the second insulating layer 761d is formed in a region at least corresponding to the IC chip 751a or 751b on a surface of the resin adhesive layer 761c. In another embodiment, since at least an edge portion of the resin adhesive layer 761c is adhered to the ground pads 755, the second insulating layer 761d may be formed to have a smaller area than the resin adhesive layer 761c. For example, the second insulating layer 761d may have an area that is equal to or larger than an area corresponding to the IC chip(s) 751a or 751b and is smaller than an area of the resin adhesive layer 761c.

As described above, the shielding member according to various embodiments of the present disclosure is of a thin film having a size corresponding to the area where the IC chip is arranged, and an edge portion of the shielding member is attached to the ground pad (and/or the shield frame) on the circumference of the area where the IC chip is arranged. Thus, the resin adhesive layer of the shielding member according to various embodiments of the present disclosure is intended to provide electric connection while adhering the shielding layer to the ground pad, and thus may be formed only in the edge of the shielding member. For example, the second insulating layer (e.g., the second insulating layer 761d of FIG. 7) is formed inner from the shielding layer (e.g., the shielding layer 761b of FIG. 7) and is formed to have a smaller area than the shielding layer 761b, and the resin adhesive layer (e.g., the resin adhesive layer 761c of FIG. 7) is formed in an edge on one surface of the shielding layer 761b to have a closed curve shape enclosing the second insulating layer 761d.

In an embodiment, the shielding member 761 is attached to the circuit board 723 in a flexibly denaturalized state to correspond to a curve based on a height difference between the IC chip(s) 751a or 751b. Even if a significant amount of time passes in a state where the shielding member 761 is attached to the circuit board 723, the resin adhesive layer 761c may maintain a constant thickness. However, if the shielding member 761 denatured into a curved form has a tendency to be restored to a plane form, the adhesive force of the resin adhesive layer 761c may be weakened. The influence of the resin adhesive layer 761c on the adhesive force may increase as a change in the gradient of the curve of the shielding member 761 increases.

According to various embodiments of the present disclosure, if the shielding member 761 is attached to the circuit board 723 in a state of being flexibly (curvedly) denaturalized, the curve of the shielding member 761 is made gentle in a region adjacent to at least the ground pads 755, thereby maintaining the adhesive force of the resin adhesive layer 761 stable. For example, the ground pad 755 maintains a predetermined distance or more with its closest IC chip (e.g., the IC chip 751b), thereby maintaining the curve of the shielding member 761 gentle in the resin adhesive layer 761c and a region adjacent thereto.

In an embodiment, when the ground pad 755 is arranged spaced apart from the IC chip with an interval that is equal to and/or longer than a half of a height of the IC chip closest to the ground pad 755 from a surface of the circuit board 723, the stable adhesive force of the resin adhesive layer 761c may be maintained. The interval between the ground pad 755 and the IC chip adjacent thereto may be properly set based on the adhesive force of the resin adhesive layer 761c, the efficiency of the use of the surface area of the circuit board 723, and so forth.

FIGS. 8 through 10 are cross-sectional views of various structures of a shielding member 861 of an electronic device according to another one of various embodiments of the present disclosure.

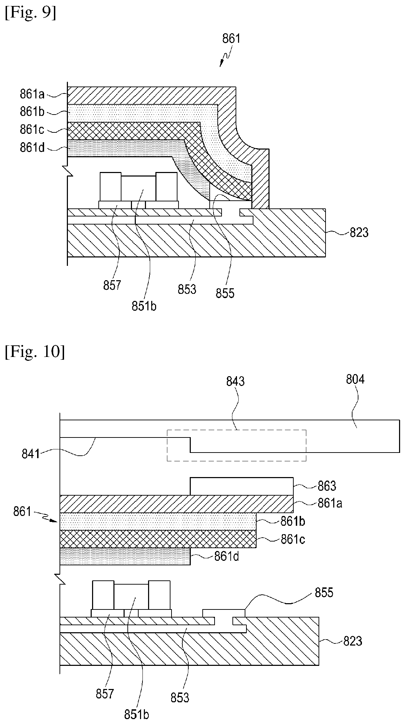

Referring to FIGS. 8 and 9, the shielding member 861 may include a first insulating layer 861a, a shielding layer 861b, a resin adhesive layer 861c, and/or a second insulating layer 861d, and is attached to the circuit board 823 with an IC chip 851b therebetween. The IC chip 851b is mounted on the circuit board 823 through at least one connection pad 857, and a ground pad 855 is provided on the circumference of a region where the IC chip 851b is mounted. The circuit board 823 may include at least one ground layer 853, and the ground pad 855 may be connected to the ground layer 853 through a via-hole, etc.

In an embodiment, the shielding layer 861b and the resin adhesive layer 861c are formed to have a smaller area than the first insulating layer 861a, and the second insulating layer 861d is formed to have a smaller area than the resin adhesive layer 861c. In an embodiment, the second insulating layer 861d is formed to have an area that is equal to or larger than an area corresponding to the IC chip 851b. For example, when the shielding member 861 is adhered to the circuit board 823 while the curvedly denaturalized shielding member 861 enclosing the IC chip 851b, the resin adhesive layer 861c may be adhered to the ground pad 855 in an edge of the shielding member 861 and the IC chip 851b and the resin adhesive layer 861c (and/or the shielding layer 861b) may be insulated from each other by the second insulating layer 861d. In another embodiment, the first insulating layer 861a is formed to have a larger area than the shielding layer 861b and/or the resin adhesive layer 861c, such that the shielding member 861 is adhered to the circuit board 823 in a state where the first insulating layer 861a encloses the shielding layer 861b and/or an end portion of the adhesive layer 861c. For example, the shielding layer 861b and/or the resin adhesive layer 861c may be electrically connected to the ground layer 853, while being insulated from the IC chip 851b or an external environment.

Referring to FIG. 10, the electronic device and/or the shielding member 861 according to various embodiments of the present disclosure may further include an elastic member 863 arranged on the other surface of the insulating layer 861a. The elastic member 863 may have a closed curve shape along an edge region on the other surface of the first insulating layer 861a, and may be formed in the form of a sponge or a phorone tape. The electronic device (e.g., the electronic device 100 of FIG. 1) according to various embodiments of the present disclosure may include a support member 804 (e.g., the support member 104 of FIG. 1), and the support member 804 may be disposed to face the circuit board 823 with the shielding member 861 therebetween.

The support member 804 at least partially interferes with the elastic member 863, and for example, may press the elastic member 863 in a direction for causing the elastic member 863 to closely contact the circuit board 823. In an embodiment, the support member 804 may further include a recessed portion 841 on a surface, and the recessed portion 841 may be positioned corresponding to the region where the IC chip 851b is arranged on the circuit board 823. For example, if the IC chip 851b is disposed to protrude on a surface of the circuit board 823, the recessed portion 841 may at least partially receive the IC chip 851b and a portion (e.g., a portion 843) of the support member 804 adjacent to the recessed portion 841 presses the elastic member 863.

As mentioned above, the resin adhesive layer 861c may maintain a constant thickness after being hardened, but the shielding member 861 has a tendency to be restored to a plane form. The electronic device (e.g., the electronic device 100 of FIG. 1) according to various embodiments of the present disclosure presses an edge region of the shielding member 861 by using the support member 804 and/or the elastic member 863, such that the resin adhesive layer 861c may further maintain its state of being adhered to the ground pad 855 more stably.

As described above, the shielding member according to various embodiments of the present disclosure provides more stable shielding performance than a shielding member including a general resin adhesive, and provides shielding performance equal to a shield can having a rigid structure. In another embodiment, the shielding member according to various embodiments of the present disclosure stabilizes connection between the shielding layer and the ground, thereby securing stable shielding performance while reducing the thickness of the insulating layer, the shielding layer, and/ or the resin adhesive layer. For example, a shielding member according to various embodiments of the present disclosure may be manufactured to have a smaller thickness, contributing to reduction of the thickness of the electronic device.

As described above, a shielding member according to various embodiments of the present disclosure is a shielding member of a film type including an insulating layer, a shielding layer formed on a surface of the insulating layer, and a resin adhesive layer formed on a surface of the shielding layer, in which the resin adhesive layer may include a thermoplastic resin adhesive to which an electrically conductive powder is added.

According various embodiments, the shielding layer may include copper foil.

According various embodiments, the shielding layer may include a deposition layer formed by film-depositing copper (Cu) or silver (Ag) on the surface of the insulating layer.

According various embodiments, the resin adhesive layer may include epoxy resin or polyester resin.

According various embodiments, the shielding member may further include a second insulating layer formed on a surface of the resin adhesive layer, in which the second insulating layer has a smaller area than the resin adhesive layer.

According various embodiments, the shielding layer and the resin adhesive layer may have smaller areas than the insulating layer.

An electronic device according to various embodiments of the present disclosure may include the above-described shielding member and a circuit board coupled with the shielding member to face the shielding member, in which the shielding member is electrically connected to ground of the circuit board.

According to various embodiments of the present disclosure, an electronic device includes a circuit board, on a surface of which at least one ground pad is provided, and a shielding member attached on a surface of the circuit board and electrically connected to the ground pad, in which the shielding member includes an insulating layer, a shielding layer formed on a surface of the insulating layer, and a resin adhesive layer formed on a surface of the shielding layer, in which the resin adhesive layer includes a thermoplastic resin adhesive to which electrically conductive powder is added.

According various embodiments, the shielding member may further include a shield frame mounted on a surface of the circuit board, and an edge portion of the resin adhesive layer is attached to the shield frame and is connected to the ground pad through the shield frame.

According various embodiments, a space enclosed by the shield frame may be molded using synthetic resin.

According various embodiments, a portion of the resin adhesive layer may be adhered to the ground pad to electrically connect the shielding layer to the ground pad.

According various embodiments, the electronic device may further include at least one IC chip mounted on a surface of the circuit board, in which the shielding member is attached to the circuit board with the IC chip therebetween.

According various embodiments, the ground pad may be formed in a closed curve shape along a circumference of a region where the IC chip is mounted.

According various embodiments, a plurality of ground pads may be arranged along a circumference of a region where the IC chip is mounted.

According various embodiments, the shielding member may further include a second insulating layer formed on a surface of the resin adhesive layer and positioned to correspond to the IC chip, and the second insulating layer may have a smaller area than the resin adhesive layer and has an area that is equal to or larger than a region corresponding to the IC chip.

According various embodiments, the shielding member may further include an elastic member provided on the other surface of the insulating layer.

According various embodiments, the elastic member may have a closed curve shape along an edge region of the insulating layer.

According various embodiments, the electronic device may further include a support member disposed to face the circuit board with the shielding member between the support member and the circuit board, in which the support member presses the elastic member in a direction for causing the elastic member to closely contact the circuit board.

According various embodiments, the electronic device may further include at least one IC chip mounted on a surface of the circuit board and a recessed portion formed on the support member to at least partially receive the IC chip.

According various embodiments, the shielding layer and the resin adhesive layer may have smaller areas than the insulating layer.

Although the present disclosure has been described with an exemplary embodiment, various changes and modifications may be suggested to one skilled in the art. It is intended that the present disclosure encompass such changes and modifications as fall within the scope of the appended claims.

## Claims

1. An electronic device comprising:
a circuit board (823) comprising at least one ground pad (855); and
a shielding member (861) attached to the circuit board (823) and electrically connected to the ground pad (855),
wherein the shielding member (861) comprises:
an insulating layer (861a);
a shielding layer (861b) formed on a surface of the insulating layer (861a); and
a resin adhesive layer (861c) formed on a surface of the shielding layer (861b),
wherein the resin adhesive layer (861c) comprises a thermoplastic resin adhesive comprising electrically conductive powder, and
wherein the shielding layer (861b) and the resin adhesive layer (861c) have smaller areas than that of the insulating layer (861a).

2. The shielding member of claim 1, wherein the shielding layer (861b) comprises at least one of copper foil and a deposition layer comprising film-deposited copper, Cu, or silver, Ag.

3. The shielding member of claim 1, further comprising a second insulating layer (861d) formed on a surface of the resin adhesive layer (861c),
wherein the second insulating layer (861d) has a smaller area than that of the resin adhesive layer (861c).

4. The electronic device of claim 1, wherein the shielding member (306, 861) further comprises a shield frame (363) mounted to the circuit board (305, 823), and an edge portion of the resin adhesive layer (361c, 861c) is attached to the shield frame (363) and is connected to the ground pad (355, 855) through the shield frame (363).

5. The electronic device of claim 1, wherein a portion of the resin adhesive layer (861c) is adhered to the ground pad (855) to electrically connect the shielding layer (861b) to the ground pad (855).

6. The electronic device of claim 1, further comprising at least one integrated circuit, IC, chip (851b) mounted to the circuit board (823),
wherein the shielding member (861) is attached to the circuit board (823) with the IC chip (851b) therebetween.

7. The electronic device of claim 6, wherein the ground pad (555a, 855) is formed in a closed curve shape along a circumference of a region where the IC chip (551a, 551b, 851b) is mounted.

8. The electronic device of claim 6, wherein a plurality of ground pads (555b, 855) are arranged along a circumference of a region where the IC chip (551a, 551b, 851b) is mounted.

9. The electronic device of claim 6, wherein the shielding member (761, 861) further comprises a second insulating layer (761d, 861d) formed on the resin adhesive layer (761c, 861c) and positioned to correspond to the IC chip (751a, 751b, 851b), and the second insulating layer (761d, 861d) has a smaller area than that of the resin adhesive layer (761c, 861c) and has an area that is equal to or larger than a region corresponding to the IC chip (751a, 751b, 851b).

10. The electronic device of claim 1, wherein the shielding member (861) comprises an elastic member (863) provided on another surface of the insulating layer (861a).

11. The electronic device of claim 10, wherein the elastic member (863) has a closed curve shape along an edge region of the insulating layer (861a).

12. The electronic device of claim 10, further comprising a support member (804) disposed to face the circuit board (823) with the shielding member (861) between the support member (804) and the circuit board (823),
wherein the support member (804) presses the elastic member (863) in a direction for causing the elastic member (863) to closely contact the circuit board (823).

13. The electronic device of claim 12, further comprising:
at least one IC chip (851b) mounted to the circuit board (823); and
a recessed portion (841) formed on the support member (804) to at least partially receive the IC chip (851b).

## Patentansprüche

1. Elektronische Vorrichtung, umfassend:
eine Leiterplatte (823), die zumindest ein Erdungspad (855) umfasst; und
ein Abschirmelement (861), das an der Leiterplatte (823) angebracht und elektrisch mit dem Erdungspad (855) verbunden ist;
wobei das Abschirmelement (861) Folgendes umfasst:
eine Isolierschicht (861a);
eine Abschirmschicht (861b), die auf einer Oberfläche der Isolierschicht (861a) gebildet ist; und
eine Harzklebstoffschicht (861c), die auf einer Oberfläche der Abschirmschicht (861b) gebildet ist,
wobei die Harzklebstoffschicht (861c) einen thermoplastischen Harzklebstoff umfasst, der elektrisch leitendes Pulver umfasst, und
wobei die Abschirmschicht (861b) und die Harzklebstoffschicht (861c) kleinere Bereiche als derjenige der Isolierschicht (861a) aufweisen.

2. Abschirmelement nach Anspruch 1, wobei die Abschirmschicht (861b) zumindest eines von Kupferfolie und einer Abscheidungsschicht umfasst, die filmabgeschiedenes Kupfer, Cu, oder Silber, Ag, umfasst.

3. Abschirmelement nach Anspruch 1, ferner umfassend eine zweite Isolierschicht (861d), die auf einer Oberfläche der Harzklebstoffschicht (861c) gebildet ist,
wobei die zweite Isolierschicht (861d) einen kleineren Bereich als derjenige der Harzklebstoffschicht (861c) aufweist.

4. Elektronische Vorrichtung nach Anspruch 1, wobei das Abschirmelement (306, 861) ferner einen Abschirmrahmen (363) umfasst, der an der Leiterplatte (305, 823) montiert ist, und ein Randabschnitt der Harzklebstoffschicht (361c, 861c) an dem Abschirmrahmen (363) angebracht ist und durch den Abschirmrahmen (363) mit dem Erdungspad (355, 855) verbunden ist.

5. Elektronische Vorrichtung nach Anspruch 1, wobei ein Abschnitt der Harzklebstoffschicht (861c) an dem Erdungspad (855) haftet, um die Abschirmschicht (861b) elektrisch mit dem Erdungspad (855) zu verbinden.

6. Elektronische Vorrichtung nach Anspruch 1, ferner umfassend zumindest einen Chip (851b) einer integrierten Schaltung, IC, der an der Leiterplatte (823) montiert ist,
wobei das Abschirmelement (861) an der Leiterplatte (823) angebracht ist, mit dem IC-Chip (851b) dazwischen.

7. Elektronische Vorrichtung nach Anspruch 6, wobei das Erdungspad (555a, 855) in einer geschlossenen Kurvenform entlang eines Umfangs einer Region gebildet ist, in welcher der IC-Chip (551a, 551b, 851b) montiert ist.

8. Elektronische Vorrichtung nach Anspruch 6, wobei eine Vielzahl von Erdungspads (555b, 855) entlang eines Umfangs einer Region angeordnet ist, in welcher der IC-Chip (551a, 551b, 851b) montiert ist.

9. Elektronische Vorrichtung nach Anspruch 6, wobei das Abschirmelement (761, 861) ferner eine zweite Isolierschicht (761d, 861d) umfasst, die auf der Harzklebstoffschicht (761c, 861c) gebildet und positioniert ist, um dem IC-Chip (751a, 751b, 851b) zu entsprechen, und die zweite Isolierschicht (761d, 861d) einen kleineren Bereich als derjenige der Harzklebstoffschicht (761c, 861c) aufweist und einen Bereich aufweist, der gleich einer oder größer als eine Region ist, die dem IC-Chip (751a, 751b, 851b) entspricht.

10. Elektronische Vorrichtung nach Anspruch 1, wobei das Abschirmelement (861) ein elastisches Element (863) umfasst, das auf einer anderen Oberfläche der Isolierschicht (861a) bereitgestellt ist.

11. Elektronische Vorrichtung nach Anspruch 10, wobei das elastische Element (863) eine geschlossene Kurvenform entlang einer Randregion der Isolierschicht (861a) aufweist.

12. Elektronische Vorrichtung nach Anspruch 10, ferner umfassend ein Stützelement (804), das angeordnet ist, um der Leiterplatte (823) zugewandt zu sein, mit dem Abschirmelement (861) zwischen dem Stützelement (804) und der Leiterplatte (823),
wobei das Stützelement (804) das elastische Element (863) in eine Richtung drückt, um zu bewirken, dass das elastische Element (863) die Leiterplatte (823) eng kontaktiert.

13. Elektronische Vorrichtung nach Anspruch 12, ferner umfassend:
zumindest einen IC-Chip (851b), der an der Leiterplatte (823) montiert ist; und
einen ausgesparten Abschnitt (841), der auf dem Stützelement (804) gebildet ist, um den IC-Chip (851b) zumindest teilweise aufzunehmen.

## Revendications

1. Dispositif électronique comprenant :
une carte de circuit (823) comprenant au moins une plaque de mise à la terre (855) ; et un élément de blindage (861) fixé à la carte de circuit (823) et raccordé électriquement à la plaque de mise à la terre (855),
ledit élément de blindage (861) comprenant : une couche isolante (861a) ;
une couche de blindage (861b) formée sur une surface de la couche isolante (861a) ; et une couche adhésive en résine (861c) formée sur une surface de la couche de blindage (861b), ladite couche adhésive en résine (861c) comprenant un adhésif en résine thermoplastique comprenant une poudre électroconductrice, et
ladite couche de blindage (861b) et ladite couche adhésive en résine (861c) possédant des superficies inférieures à celle de la couche isolante (861a).

2. Elément de blindage selon la revendication 1, ladite couche de blindage (861b) comprenant au moins une feuille de cuivre et une couche de dépôt comprenant du cuivre (Cu) ou de l'argent (Ag) déposé par film.

3. Elément de blindage selon la revendication 1, comprenant en outre une seconde couche isolante (861d) formée sur une surface de la couche adhésive en résine (861c),
ladite seconde couche isolante (861d) possédant une superficie plus petite que celle de la couche adhésive en résine (861c).

4. Dispositif électronique selon la revendication 1, ledit élément de blindage (306, 861) comprenant en outre un cadre de blindage (363) monté sur la carte de circuit (305, 823), et une partie de bord de la couche adhésive en résine (361c, 861c) étant fixée au cadre de blindage (363) et étant raccordée à la plaque de mise à la terre (355, 855) à travers le cadre de blindage (363).

5. Dispositif électronique selon la revendication 1, une partie de la couche adhésive de résine (861c) adhérant à la plaque de mise à la terre (855) pour raccorder électriquement la couche de blindage (861b) à la plaque de mise à la terre (855).

6. Dispositif électronique selon la revendication 1, comprenant en outre au moins une puce de circuit intégré (IC) (851b) montée sur la carte de circuit (823),
ledit élément de blindage (861) étant fixé à la carte de circuit (823) avec la puce IC (851b) entre eux.

7. Dispositif électronique selon la revendication 6, ladite plaque de mise à la terre (555a, 855) étant façonnée en une forme de courbe fermée le long d'une circonférence d'une zone où la puce IC (551a, 551b, 851b) est montée.

8. Dispositif électronique selon la revendication 6, une pluralité de plaques de mise à la terre (555b, 855) étant agencées le long d'une circonférence d'une zone où la puce IC (551a, 551b, 851b) est montée.

9. Dispositif électronique selon la revendication 6, ledit élément de blindage (761, 861) comprenant en outre une seconde couche isolante (761d, 861d) formée sur la couche adhésive en résine (761c, 861c) et positionnée pour correspondre à la puce IC (751a, 751b, 851b), et la seconde couche isolante (761d, 861d) possédant une superficie inférieure à celle de la couche adhésive en résine (761c, 861c) et possédant une superficie qui est supérieure ou égale à une zone correspondant à la puce IC (751a, 751b, 851b).

10. Dispositif électronique selon la revendication 1, ledit élément de blindage (861) comprenant un élément élastique (863) disposé sur une autre surface de la couche isolante (861a).

11. Dispositif électronique selon la revendication 10, ledit élément élastique (863) possédant une forme de courbe fermée le long d'une zone de bord de la couche isolante (861a).

12. Dispositif électronique selon la revendication 10, comprenant en outre un élément de support (804) disposé pour faire face à la carte de circuit (823) avec l'élément de blindage (861) entre l'élément de support (804) et la carte de circuit (823),
ledit élément de support (804) pressant l'élément élastique (863) dans une direction pour amener l'élément élastique (863) à entrer en contact étroit avec la carte de circuit (823).

13. Dispositif électronique selon la revendication 12, comprenant en outre :
au moins une puce IC (851b) montée sur la carte de circuit imprimé (823) ; et une partie évidée (841) formée sur l'élément de support (804) pour recevoir au moins partiellement la puce IC (851b).
